Europäisches Patentamt

European Patent Office

Office européen des brevets

(11) Numéro de publication: **0 073 707**
A1

## (12) DEMANDE DE BREVET EUROPEEN

(21) Numéro de dépôt: **82401544.0**

(51) Int. Cl.³: **H 03 J 1/02,** H 03 J 3/14

(22) Date de dépôt: **17.08.82**

(30) Priorité: **31.08.81 FR 8116545**

(71) Demandeur: **THOMSON-BRANDT, 173, Boulevard Haussmann, F-75379 Paris Cedex 08 (FR)**

(43) Date de publication de la demande: **09.03.83 Bulletin 83/10**

(72) Inventeur: **Bouchant, Jean-CHarles, THOMSON-CSF SCPI 173, bld Haussmann, F-75379 Paris Cedex 08 (FR)**

(84) Etats contractants désignés: **DE GB IT**

(74) Mandataire: **Grynwald, Albert et al, THOMSON-CSF SCPI 173, Bld Haussmann, F-75379 Paris Cedex 08 (FR)**

(54) Récepteur comportant un dispositif d'affichage de fréquence.

(57) L'invention concerne un récepteur comportant un circuit de réception, un détecteur d'accord et un dispositif d'affichage de fréquence. L'affichage apparaît sur le cadran 11 du récepteur selon un premier mode en l'absence d'un signal issu du détecteur d'accord et représentant un accord sur une station, et selon au moins un deuxième mode visuellement distinct du premier en la présence d'un tel signal. Selon un mode de réalisation, ladite indication apparaît sur le cadran selon un deuxième mode en présence d'un signal associé à un accord exact et selon un troisième mode visuellement distinct des deux premiers en présence d'un signal associé à un accord approximatif. Les modes d'indication sont par exemple des couleurs distinctes.

# RECEPTEUR COMPORTANT UN DISPOSITIF D'AFFICHAGE DE FREQUENCE

La présente invention a pour objet un récepteur comprenant un dispositif d'affichage de fréquence.

Les récepteurs modulation d'amplitude (MA) et/ou modulation de fréquence (MF) sont en général équipés d'un dispositif d'affichage de fréquence constitué d'un cadran gradué en fréquence et d'une aiguille solidaire du système de recherche des stations (condensateur variable, self variable, commande de tension d'une diode Varicap). Dans le cas d'une recherche de stations utilisant une ou plusieurs diodes Varicap, il est intéressant d'avoir recours à un cadran gradué en fréquence et en longueur d'onde associé à un dispositif d'affichage de fréquence du type aiguille lumineuse électronique qui est en général une rampe de diodes électroluminescentes, associée à un circuit de commande. Une seule diode est éclairée, commandée par un élément à seuil indiquant la fréquence sur le cadran, après étalonnage.

Quelque soit le mode de repérage utilisé, il est important de caler le récepteur exactement sur la fréquence de l'émetteur. Pour cela, il faut avoir recours à un indicateur d'accord. Ce peut être un simple galvanomètre à point milieu ou un système électronique plus ou moins sophistiqué.

Ces systèmes connus ont pour inconvénient d'obliger l'utilisateur à porter son regard alternativement sur l'indicateur d'accord, et sur le cadran de l'appareil où se trouve l'indication de fréquence.

La présente invention a pour objet un récepteur ne présentant pas l'inconvénient ci-dessus.

L'invention concerne ainsi un récepteur comportant un circuit de réception, un détecteur d'accord et un dispositif d'affichage de fréquence, caractérisé en ce que le détecteur d'accord est associé

2

0073707

au dispositif d'affichage de fréquence de telle façon que l'affichage de fréquence apparaisse selon un premier mode en l'absence d'un signal issu du détecteur d'accord et représentant un accord sur une station, et selon au moins un deuxième mode visuellement distinct du premier en présence d'un tel signal.

Selon un mode de réalisation de l'invention, en présence d'un signal représentant un accord sur une station, ledit détecteur d'accord est associé au dispositif d'affichage de fréquence de telle façon que l'affichage apparaisse sur la cadran selon ledit second mode en présence d'un signal associé à un accord exact ou présumé exact et selon un troisième mode visuellement distinct des deux premiers en présence d'un signal associé à un accord approximatif.

Le dispositif d'affichage de fréquence peut comporter un circuit de commande d'affichage et un dispositif d'affichage lumineux de fréquence.

Selon un mode de réalisation préférentiel, lesdits modes d'indication consistent en des couleurs distinctes.

Ainsi, le dispositif d'affichage lumineux de fréquence peut consister en une aiguille lumineuse comprenant une pluralité d'éléments d'affichage dont chacun est susceptible de faire apparaître une indication suivant au moins deux couleurs distinctes, et être associé à un circuit de commande d'aiguille lumineuse recevant du circuit de réception du récepteur une tension de commande représentative de la fréquence sur laquelle le récepteur est accordé et produisant en conséquence à une de ses n sorties un signal représentatif de ladite fréquence, le détecteur d'accord recevant dudit circuit de réception un signal représentant le champ reçu et/ou au moins un signal issu d'un discriminateur dudit circuit de réception. Chaque élément d'affichage peut être constitué par exemple de deux ou bien trois composants électroluminescents, par exemple des diodes.

D'autre part, pour une émission en modulation d'amplitude, le détecteur d'accord reçoit du circuit de réception le champ modulation d'amplitude et/ou le zéro et la courbe en S d'un discriminateur modulation d'amplitude.

Pour une émission en modulation de fréquence, le détecteur d'accord reçoit du circuit de réception au moins le zéro du discriminateur, et éventuellement la courbe en S de celui-ci et/ou le champ modulation de fréquence.

L'invention sera mieux comprise à la lecture de la description qui va suivre, donnée à titre d'exemple non limitatif, en se reportant aux dessins ci-annexés et où :

- la figure 1 représente un cadran gradué du type aiguille lumineuse,

- les figures 2 à 5 représentent des modes de réalisation de l'invention mettant en oeuvre chacun une rampe de diodes électroluminescentes, associée à un circuit logique selon une logique parallèle,

- les figures 6 à 10 représentent des modes de réalisation de l'invention mettant en oeuvre chacun une rampe de diodes électroluminescentes selon une logique série,

- la figure 11 représente une variante où le circuit de réception du récepteur est pourvu d'un discriminateur en modulation d'amplitude et en modulation de fréquence.

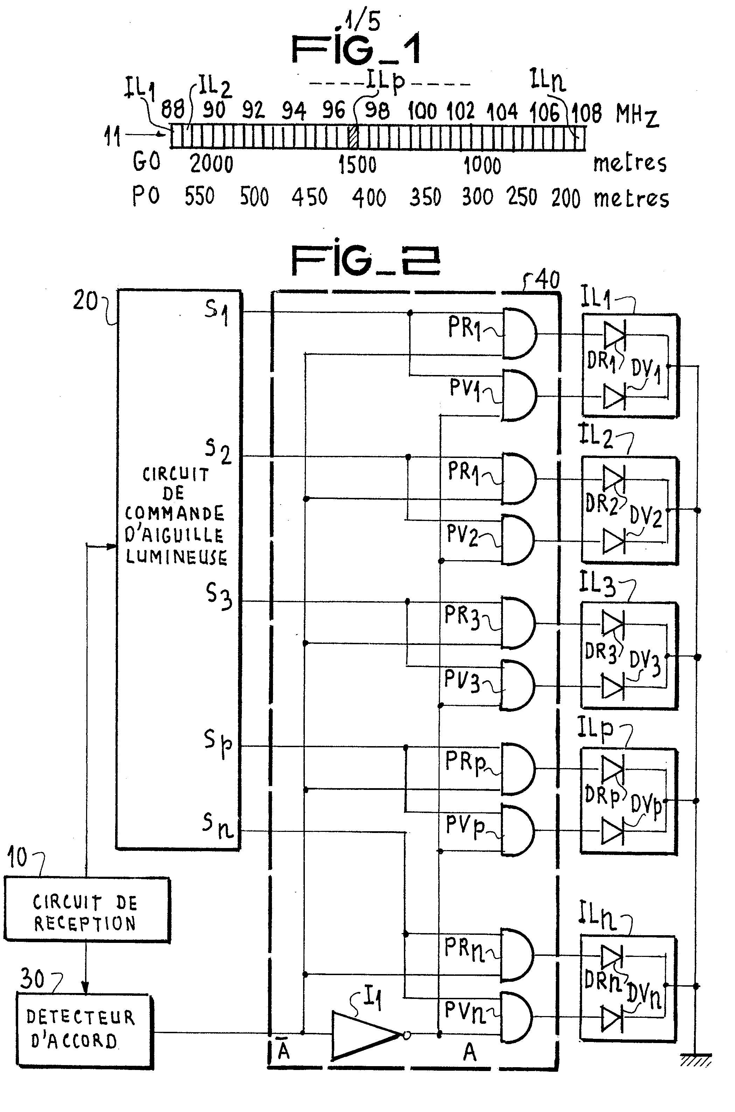

La figure 1 représente un dispositif d'affichage lumineux de fréquence 11 du type aiguille lumineuse comportant un certain nombre de composants électroluminescents ($IL_1$, $IL_2$, ..., $IL_p$, ..., $IL_n$). Une telle aiguille lumineuse peut être constituée par une rampe de diodes électroluminescentes. L'aiguille lumineuse est associée à des graduations correspondant respectivement à la bande modulation de fréquence MF, et à une ou plusieurs bandes modulation d'amplitude (grandes ondes, petites ondes, etc...). L'indication lumineuse est obtenue par éclairage d'un seul des composants, par exemple le composant $IL_p$, p pouvant varier de 1 à n.

Pour réaliser un tel affichage, le récepteur comprend classiquement un circuit de réception, ainsi qu'un circuit de commande d'affichage. Un récepteur classique comprend aussi en général un détecteur d'accord qui réalise une visualisation d'accord, indépendamment de l'affichage de fréquence.

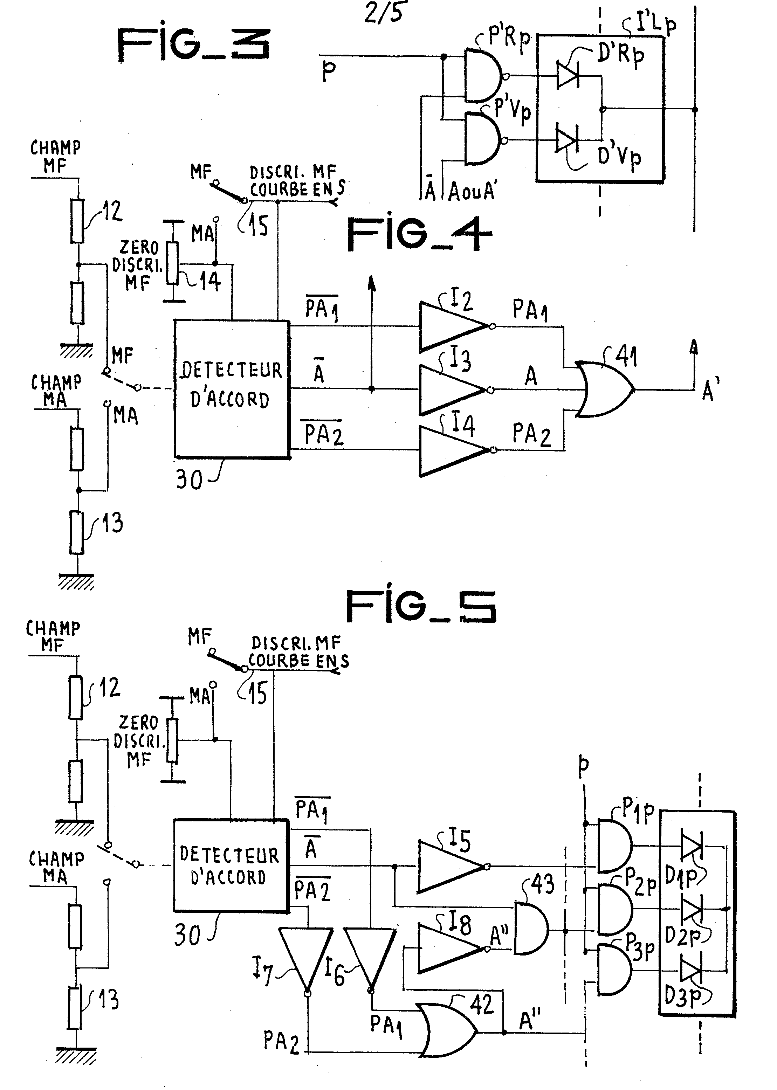

La figure 2 représente un récepteur selon l'invention comportant un circuit de réception 10 qui fournit, de manière connue en soi, un ou plusieurs signaux à un détecteur d'accord 30, ainsi qu'une tension de commande à un circuit 20 de commande d'aiguille lumineuse. Le dispositif 11 d'affichage lumineux de fréquence est du type aiguille lumineuse, où chaque élément photo-luminescent ($IL_1$, $IL_2$, $IL_3$, ..., $IL_p$, ..., $IL_n$), comporte deux composants électroluminescents, par exemple des diodes $DR_1$ et $DV_1$, $DR_2$ et $DV_2$, $DR_3$ et $DV_3$, ..., $DR_p$ et $DV_p$, ..., $DR_n$ et $DV_n$. Par exemple, les diodes $DR_p$, avec p variant de 1 à n, émettent dans le rouge, et les diodes $DV_p$, avec p variant de 1 à n, émettent dans le vert. Un circuit logique 40 reçoit des signaux du détecteur d'accord 30 et du circuit 20 de commande d'aiguille lumineuse, et est associé au dispositif 11 d'affichage lumineux de fréquence, en l'occurence du type aiguille lumineuse, de telle sorte que l'indication lumineuse de fréquence apparaisse sur le dispositif d'affichage lumineux de fréquence 11 selon un premier mode en absence d'un signal issu du détecteur d'accord 30 et représentant un accord sur une station, et selon au moins un deuxième mode visuellement distinct du premier en la présence d'un tel signal. Le circuit logique 40 a donc, d'une manière générale pour fonction d'interconnecter de manière appropriée le dispositif d'affichage, le circuit de commande d'affichage, par exemple du type aiguille lumineuse, et le détecteur d'accord.

Ainsi, avec les diodes rouges et vertes mentionnées ci-dessus, l'indication lumineuse de fréquence pourra apparaître en rouge s'il n'y a pas d'accord sur une station et en vert s'il y a accord sur une station.

Le mode de réalisation de la figure 2 va maintenant être décrit plus en détail. Les cathodes de toutes les diodes électroluminescentes sont réunies à la masse. En effet, les éléments électroluminescents à deux diodes se présentent généralement sous forme de boîtiers dans lesquels les cathodes des deux diodes sont communes. Le circuit logique 40 va traiter en parallèle les informations fournies par le circuit 20 de commande d'aiguilles lumineuses et par le détecteur d'accord 30. Considérons ainsi un élément électroluminescent quelconque $IL_p$, p variant de 1 à n. L'anode de sa première diode $DR_p$, qui constitue son électrode libre, est connectée à la sortie d'une porte ET $PR_p$. L'anode de sa seconde diode $DV_p$, qui constitue son électrode libre, est connectée à la sortie d'une porte ET $PV_p$. Une première entrée de la porte ET $PR_p$ ainsi qu'une première entrée de la porte ET $PV_p$ reçoivent la sortie $S_p$ de rang p du circuit 20 de commande d'aiguille lumineuse selon une logique positive, c'est-à-dire que ce signal $S_p$ est au niveau logique 1 et toutes les autres au niveau logique 0 lorsque la fréquence de réception sélectionnée correspond à l'illumination de l'élément $IL_p$ de l'aiguille lumineuse. Par exemple, le circuit de commande d'aiguille lumineuse UAA 170 de chez SIEMENS fournit directement des signaux de sortie selon une logique positive. D'autre part, le détecteur d'accord qui, par exemple en modulation de fréquence, reçoit le zéro du discriminateur du circuit de réception 10, produit à sa sortie un signal $\overline{A}$ correspondant à un accord sur une station, selon une logique négative, c'est-à-dire que lors d'un accord sur une station, cette sortie $\overline{A}$ est au niveau logique 0. On peut par exemple utiliser le détecteur d'accord LB 1450 de SANYO. Le signal $\overline{A}$ est introduit dans un inverseur $I_1$ dont la sortie est un signal A représentant donc un accord sur une station selon une logique positive. Le signal $\overline{A}$ est introduit à la deuxième entrée de la porte ET $PR_p$ de même bien entendu qu'à toutes les autres portes analogues, à savoir $PR_1$, $PR_2$, $PR_3$, ..., $PR_p$, ..., $PR_n$. De la même façon, le signal A est introduit à la deuxième entrée de chacune des portes $PV_1$, $PV_2$, $PV_3$, ..., $PV_p$, ..., $PV_n$. Dans ces conditions, si un signal logique de niveau 1 est fourni par la sortie $S_p$ (p pouvant varier de 1 à n), c'est la diode $DR_p$ quis sera éclairée en l'absence d'accord sur une station, et la diode $DV_p$ qui sera éclairée en présence d'un accord sur une station. Les diodes $PR_{p'}$ et $PV_{p'}$ (quelque soit p' ≠ p) ne seront pas éclairées puisque $S_{p'} = 0$. Avec l'exemple donné ci-dessus, l'utilisateur verra un élément lumineux

IL$_p$ de couleur rouge s'il n'y a pas d'accord sur une station, et de couleur verte s'il y a accord sur une station.

On notera que des composants électroluminescents autres que des diodes peuvent être employés. Si leurs électrodes communes sont connectées à la masse, celles-ci seront dénommées cathodes, et anodes si elles sont connectées à une tension d'alimentation.

La figure 3 est une variante de la figure 2, mettant en oeuvre par exemple des diodes dont les anodes sont connectées dans un boîtier formant l'élément électroluminescent IL$_p$. Dans un but de simplification, cette figure ne représente en effet que l'élément lumineux de rang p, la situation étant bien entendu identique pour tous les autres éléments électroluminescents. Les portes ET PR$_p$ et PV$_p$ sont simplement remplacées respectivement par des portes ET inverseuses P'R$_p$ et P'V$_p$, lesquelles reçoivent par ailleurs les mêmes signaux que dans le cas de la figure 2.

La figure 4 représente une version plus élaborée des figures 2 et 3 visant à obtenir non plus 2, mais 3 modes de visualisation de l'indication lumineuse de fréquence. Par exemple, pour des éléments électroluminescents comportant une diode rouge et une diode verte, l'indication sera rouge en l'absence d'accord, orange lors d'un accord approximatif sur une station en faisant émettre simultanément les deux diodes, et vert en présence d'un accord exact sur une station. Pour ce faire, le détecteur d'accord 30 reçoit du circuit de réception 10, non seulement le zéro du discriminateur MF, mais également la courbe en S de celui-ci de manière à pouvoir produire en sortie, de manière connue en soi, des signaux PA$_1$ et PA$_2$ représentant un accord approximatif sur une station. Par exemple, le circuit cité plus haut à titre d'exemple fournit de tels signaux avec une logique négative, c'est-à-dire qu'un accord approximatif sur une station produit en sortie un niveau logique 0 à l'une des deux sorties $\overline{PA_1}$ et $\overline{PA_2}$. En l'absence total d'accord ou en cas d'accord exact sur une station, ces deux sorties sont au niveau 1. Le signal $\overline{PA_1}$ est introduit dans un inverseur I$_2$ qui produit en sortie un signal d'accord approximatif PA$_1$ selon une logique positive. Le signal $\overline{A}$ est

introduit à l'entrée d'un inverseur $I_3$ qui produit en sortie un signal A d'accord sur une station selon une logique positive, comme le réalisait l'inverseur $I_1$ da la figure 1. Le signal $\overline{PA_2}$ est introduit à · l'entrée d'un inverseur $I_4$ qui produit en sortie un signal d'accord approximatif $PA_2$ selon une logique positive. Les signaux $PA_1$, A, et $PA_2$ sont introduits aux trois entrées d'une porte OU dont la sortie est un signal A' qui sera introduit à la deuxième entrée des portes $PV_p$ avec p variant de 1 à n dans les mêmes conditions que le signal A à la figure 2 ou la figure 3. De la même façon, le signal $\overline{A}$ est introduit à la deuxième entrée des portes ET $PR_p$ ou ET inverseuse $P'R_p$ avec p variant de 1 à n. D'autre part, la figure 4 montre que le détecteur d'accord 30 peut éventuellement recevoir des indications concernant le champ MF et le champ MA par l'intermédiaire de ponts diviseurs respectivement 12 et 13 qui permettent de régler les seuils de champ indépendanmment en MA et en MF. Cette disposition classique a, on le rappellera, un double intérêt. En modulation de fréquence, cette indication de champ est utilisée pour inhiber la sortie du détecteur d'accord, c'est-à-dire qu'en présence de champ trop faible, la sortie du détecteur d'accord ne produira pas à sa sortie de signal représentatif d'un accord sur une station, quelque soit par ailleurs la situation au niveau du discriminateur MF. Il peut en être bien entendu de même en MA. Il convient cependant de remarquer que les récepteurs MA ne sont en général pas pourvus d'un discriminateur, c'est-à-dire qu'il n'est pas possible de déterminer quand il y a exactement un accord sur une station. Ceci n'est pas en pratique très gênant, étant donné la qualité très médiocre de ce genre d'émissions qui sont bien reçues dès que le champ a un niveau satisfaisant. C'est la situation représentée à la figure 4 : en position MA, le détecteur d'accord reçoit le champ MA, mais par contre un interrupteur court-circuite les deux entrées du détecteur d'accord côté discriminateur, ce qui fait que le détecteur d'accord 30 produit en sortie un signal $\overline{A}$ égal à 1 si le champ est trop faible et un signal $\overline{A}$ égal à 0 si le champ atteint un niveau satisfaisant. Par contre les signaux $\overline{PA_1}$ et $\overline{PA_2}$ seront, quant à eux, toujours

égaux à 1. Par convention, on dira qu'un signal $\bar{A}$ égal à 0 correspondant à un champ dépassant un seuil prédéterminé, en AM sans intervention d'un discriminateur, est un signal associé à un accord présumé exact sur une station.

Le fonctionnement s'explique alors de la manière suivante : s'il n'y a aucun accord sur une station, $\bar{A}$ est égal à 1, donc une diode $DR_p$ (avec p variant de 1 à n) est allumée, en rapport avec l'indication correspondant du circuit 20 de commande d'aiguille lumineuse (sortie $S_p$ au niveau 1). Par contre, comme A = 0, de même que $PA_1$ et $PA_2$, le signal A' est égal à 0 et par conséquent la diode $DV_p$ est éteinte. On aura par exemple dans ce cas une indication lumineuse rouge. En présence d'un accord approximatif sur une station, on a, soit $PA_1 = 1$, soit $PA_2 = 1$ et par conséquent A' = 1, et d'autre part $\bar{A} = 1$, ce qui signifie que les deux diodes $DR_p$ et $DV_p$ sont allumées simultanément. Ceci correspondra par exemple à une indication lumineuse de couleur orange (combinaison du vert et du rouge). Dans le cas où il y a accord sur une station, $\bar{A} = 0$ et A = 1, donc A' = 1, ce qui signifie que la diode $DV_p$ est seule allumée, ce qui correspond par exemple pour l'utilisateur à une indication lumineuse de couleur verte.

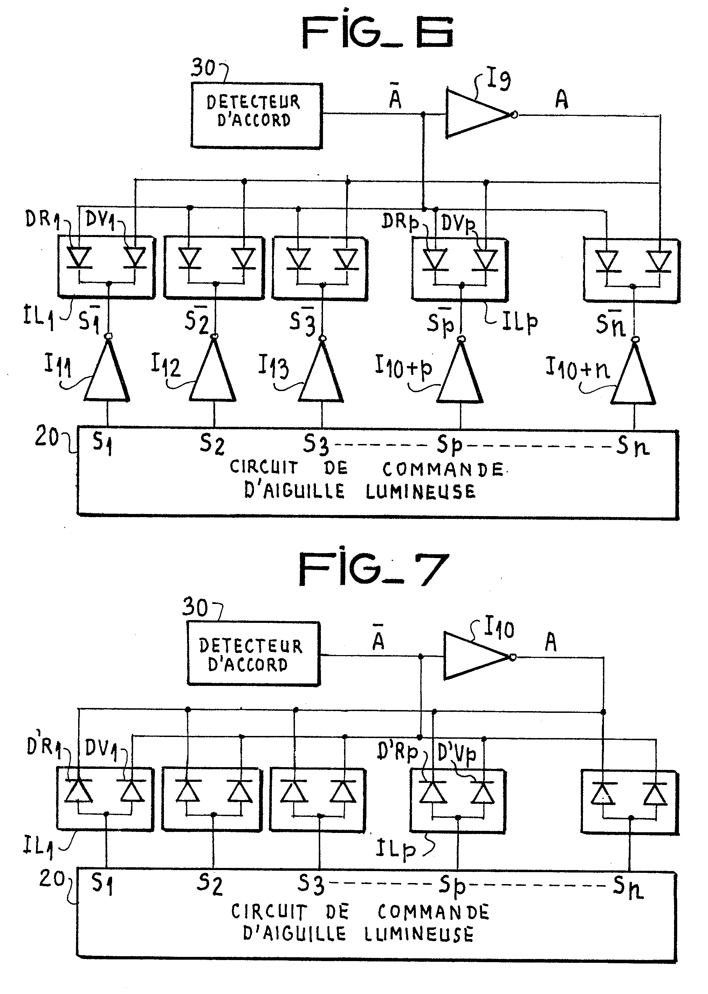

La figure 5 représente un mode de réalisation d'un affichage à trois couleurs utilisant des éléments d'affichage dont chacun comporte trois diodes électroluminescentes. L'élément d'affichage de rang p comporte ainsi les diodes $D_{1p}$, $D_{2p}$ et $D_{3p}$. Les signaux $\overline{PA_1}$ et $\overline{PA_2}$ fournis par le détecteur d'accord 30 sont inversés respectivement par des inverseurs $I_6$ et $I_7$. Les signaux $PA_1$ et $PA_2$ présents en sortie des inverseurs $I_6$ et $I_7$, sont introduits aux deux entrées d'une porte OU 42 dont le signal de sortie A" est introduit à l'entrée d'un inverseur $I_8$, dont la sortie est donc un signal $\overline{A''}$. Le signal $\bar{A}$ présent à la sortie du détecteur d'accord 30 est inversé par un inverseur $I_5$ dont la sortie est donc le signal A. Les signaux $\bar{A}$ et $\overline{A''}$ sont introduits aux entrées d'une porte ET 43. Les diodes étant représentées dans le mode cathode commune, chacune des anodes de celles-ci reçoit le signal de sortie d'une porte ET, à savoir $P_{1p}$ pour

la diode $D_{1p}$, $P_{2p}$ pour la diode $D_{2p}$, et $P_{3p}$ pour la diode $D_{3p}$, avec p variant de 1 à n. Une première entrée de chacune de ces portes ET $P_{1p}$, $P_{2p}$ et $P_{3p}$, reçoit le signal de sortie correspondant $S_p$ du circuit 20 de commande d'aiguille lumineuse. D'autre part, la seconde entrée de chaque porte ET $P_{1p}$ (avec p variant de 1 à n) reçoit le signal A en sortie de l'inverseur $I_5$, la seconde entrée de chaque porte $P_{2p}$ (avec p variant de 1 à n) reçoit le signal présent en sortie de la porte ET 43, à savoir $\overline{PA_1} + \overline{PA_2} \cdot \overline{A}$, et la seconde entrée de chaque porte $P_{3p}$ (avec p variant de 1 à n) reçoit le signal $A" = PA_1 + PA_2$ présent en sortie de la porte OU 32. Par conséquent, pour un signal de niveau logique 1 présent à la sortie $S_p$ du circuit 20 de commande d'aiguille lumineuse, l'indication lumineuse de fréquence sera réalisée selon trois modes. Au cas où il n'y a pas d'accord sur une station, on a $\overline{A} = \overline{PA_1} = \overline{PA_2} = 1$, et par conséquent $\overline{A"} = 1$, et la porte ET 43 a ses deux entrées au niveau 1 et c'est la diode $D_{2p}$ qui est la seule à être allumée (A" = A = 0). En cas d'accord aproximatif sur une station, on a, soit $\overline{PA_1} = 0$, soit $\overline{PA_2} = 0$, et par conséquent A" = 1, et d'autre part $\overline{A} = 1$ et par conséquent A = 0. Comme A" = 1, et donc $\overline{A"} = 0$, la sortie de la porte ET 43 est égale à 0, et la diode $D_{3p}$ est la seule à être allumée. Enfin, en cas d'accord exact sur une station, on a $\overline{A} = 0$ et $\overline{PA_1}$ et $\overline{PA_2} = 1$, ce qui signifie que A = 1, A" = 0 et $\overline{A"} = 1$, donc que la sortie de la porte ET 43 est égale à 0; dans ces conditions, la diode $D_{1p}$ est la seule à être allumée.

On notera que, comme dans le cas de la figure 3, pour obtenir un fonctionnement avec des diodes dont l'anode est commune, il suffit de remplacer les portes ET $P_{1p}$, $P_{2p}$ et $P_{3p}$ par des portes ET inverseuses.

Les figures 6 à 10 représentent les variantes de l'invention suivant une logique série, c'est-à-dire que chaque composant électroluminescent reçoit sur une électrode un signal correspondant à l'état logique du détecteur d'accord, et sur l'autre électrode un signal correspondant à l'état logique du circuit 20 de commande d'aiguille lumineuse. Les composants électroluminescents doivent être alors des diodes ou des composants analogues présentant un sens préférentiel d'actionnement.

A la figure 6 donc, chaque élément d'affichage $IL_p$ (avec p variant de 1 à n) est composé de deux diodes électroluminescentes $DR_p$ et $DV_p$, dont les cathodes sont réunies. Cette cathode commune reçoit le signal $\overline{S_p}$ correspondant à la $p^{ième}$ sortie du circuit 20 de commande d'aiguille lumineuse selon une logique négative, à savoir dans le cas d'espèce après inversion par un inverseur $I_{10+p}$. Les diodes $DR_p$ (avec p variant de 1 à n) reçoivent à leurs anodes le signal $\overline{A}$ du détecteur d'accord. Les diodes $DV_p$ (avec p variant de 1 à n) reçoivent à leurs anodes le signal $A$ représentant l'accord sur une station suivant une logique positive, à savoir après inversion par un inverseur $I_9$. L'indication lumineuse au niveau du $p^{ième}$ élément d'affichage $IL_p$ est réalisée de la manière suivante : pour $S_p = 1$, on a $\overline{S_p} = 0$; s'il n'y a pas d'accord sur une station, on a $\overline{A} = 1$, et c'est la diode $DR_p$ qui s'allume; par contre s'il y a accord sur une station, on a $A = 1$, et c'est la diode $DV_p$ qui s'allume. Les autres diodes restent en tout état de cause éteintes, puisque on a $S_{p'} = 1$ (quelque soit p' différent de p), ce qui fait que les diodes $DR_{p'}$ et $DV_{p'}$ sont, soit polarisées en inverse, soit reçoivent à chacune leurs électrodes un signal correspondant à un niveau logique 1.

La figure 7 représente un circuit équivalent à celui de la figure 6 dans le cas où ce sont les anodes des diodes des éléments d'affichage $I'L_p$ qui sont connectées ensemble. Dans ce cas, l'anode commune de l'élément d'affichage $I'L_p$ reçoit la sortie $S_p$ du circuit 20 de commande d'aiguille lumineuse (p variant de 1 à n). La cathode de chaque diode $DV_p$ (avec p variant de 1 à n) reçoit le signal $\overline{A}$ du détecteur d'accord 30, et la cathode de chaque diode $DR_p$ (avec p variant de 1 à n) reçoit le signal $A$ du détecteur d'accord, selon une logique positive, à savoir après inversion par un inverseur $I_{10}$. L'affichage d'une fréquence par le $p^{ième}$ élément d'affichage se réalise alors de la manière suivante : on a d'une part $S_p = 1$, ce qui fait que, en l'absence d'accord, $A = 0$ et par conséquent la diode $D'R_p$ est allumée alors que, en présence d'accord $\overline{A} = 0$, et la diode

D'V$_p$ est allumée; pour les éléments p' avec p' ≠ p, les sorties S$_{p'}$ sont au niveau 0 et aucune des diodes ne peut s'allumer.

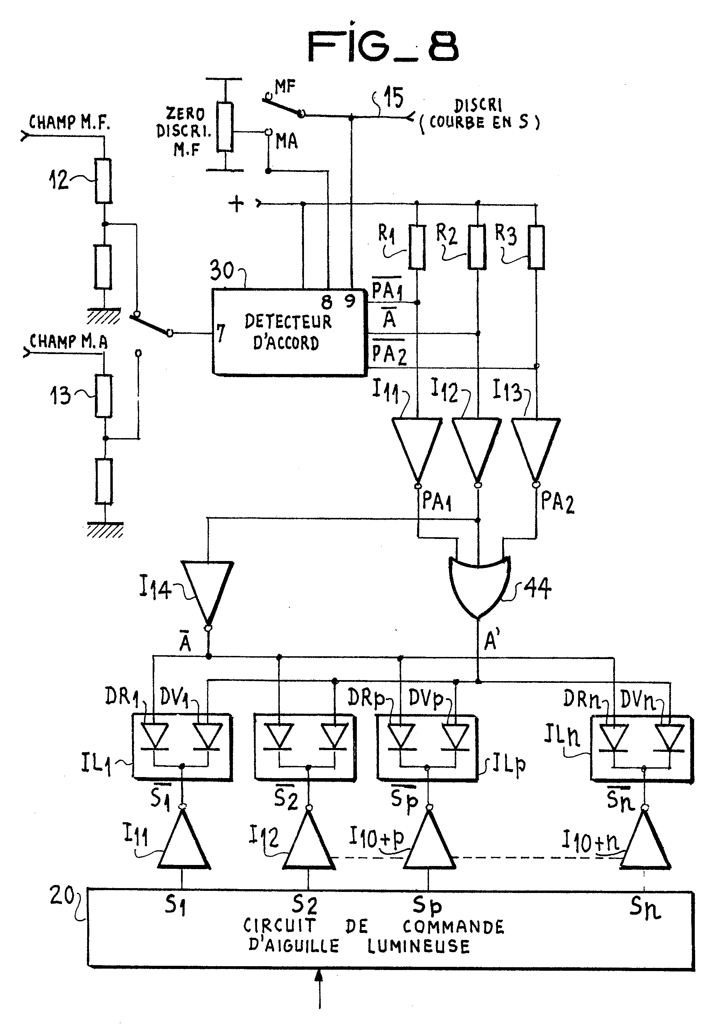

La figure 8 représente le schéma de la figure 6 adaptée à la visualisation en trois couleurs par des éléments d'affichage à deux diodes électroluminescentes. Les éléments identiques conservent les mêmes références. D'autre part le détecteur d'accord 30 reçoit les signaux du discriminateur FM et de champ dans les mêmes conditions que dans les figures 4 et 5. L'alimentation des cathodes des diodes est réalisée par le circuit 20 comme dans le cas de la figure 6 (inverseurs I$_{10+p}$). Les signaux $\overline{PA_1}$, $\overline{A}$ et $\overline{PA_2}$ sont inversés respectivement par des inverseurs I$_{11}$, I$_{12}$ et I$_{13}$, dont les sorties sont introduites dans les trois entrées d'une porte OU 44 qui produit à sa sortie un signal A' = (PA$_1$ + A + PA$_2$). D'autre part, le signal A présent à la sortie de la porte I$_{12}$ est à nouveau inversé par l'inverseur I$_{14}$ qui produit donc à sa sortie un signal $\overline{A}$. Cette disposition, en apparence redondante, a pour but de produire un niveau mieux défini en sortie, et cette disposition pourrait également s'appliquer aux cas des figures 6 et 7 décrites ci-dessus. D'autre part, dans le cas où le détecteur d'accord 30 n'est pas prévu en logique TTL, les entrées des inverseurs I$_{11}$ à I$_{13}$ sont reliées à une source d'alimentation +V par des résistances R de manière à fixer le niveau logique 1. Le signal $\overline{A}$ est appliqué à l'anode de chacune des diodes DR$_p$ (avec p variant de 1 à n). Le signal A' est appliqué à l'anode de chacune des diodes DV$_p$ (avec p variant de 1 à n). En l'absence d'accord sur une station, on a $\overline{A}$ = 1 et A' = 0 et par conséquent la diode DR$_p$ s'allume si S$_p$ est égal à 1. En cas d'accord approximatif sur une station, on a toujours $\overline{A}$ = 1, mais par contre soit PA$_1$, soit PA$_2$, est égal à 1 et par conséquent A' est lui aussi égal à 1, ce qui signifie que les diodes DR$_p$ et DV$_p$ sont allumées simultanément. En cas d'accord sur une station, on a A = 1 donc A" = 1, et $\overline{A}$ = 0, ce qui signifie que la diode DV$_p$ sera seule allumée.

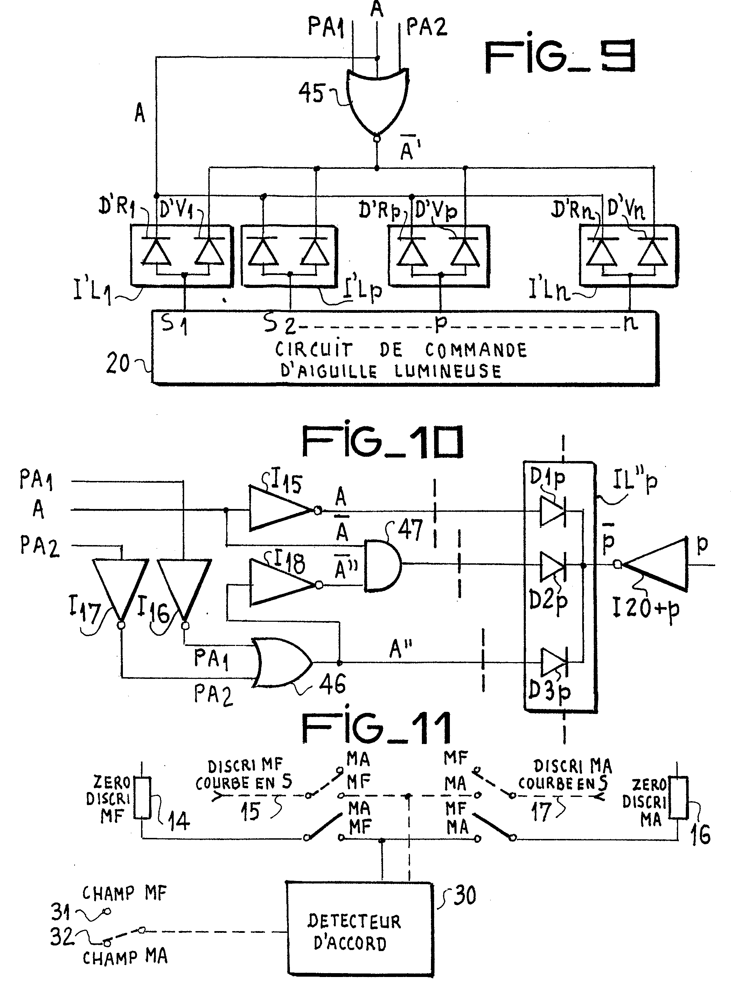

La figure 9 est une variante de la figure 8 correspondant aux cas déjà décrits dans la figure 7 où les anodes des diodes de chaque élément d'affichage sont reliées ensemble. Dans ces conditions, la porte OU 44 est remplacée par une porte OU inverseuse 45 qui reçoit également à ses entrées les signaux $PA_1$, A et $PA_2$. La cathode de chaque diode $D'R_p$ (avec p variant de 1 à n) reçoit le signal A, alors que la cathode de chaque diode $D'V_p$ (avec p variant de 1 à n) reçoit le signal $\overline{A'} = \overline{(PA_1 + A + PA_2)}$ présent à la sortie de la porte OU inverseuse 45.

La figure 10 représente une variante en logique série dans le cas où chaque élément de visualisation $IL''_p$ (avec p variant de 1 à n) comporte trois diodes électroluminescentes $D_{1p}$, $D_{2p}$ et $D_{3p}$, dont les cathodes sont réunies ensemble et connectées à la sortie $\overline{S_p}$ du circuit 20 de commande d'aiguille lumineuse, selon une logique négative, à savoir après inversion par une porte $I_{20+p}$. Les signaux $\overline{PA_1}$ et $\overline{PA_2}$ du détecteur d'accord sont inversés respectivement par des inverseurs $I_{16}$ et $I_{17}$, dont les sorties $PA_1$ et $PA_2$ sont introduits dans une porte OU 46 dont la sortie A" = $PA_1$ + $PA_2$ est introduite à son tour dans un inverseur $I_{18}$ pour produire une sortie $\overline{A''}$. D'autre part, le signal $\overline{A}$ présent à la sortie du détecteur d'accord 30 est inversé par un inverseur $I_{15}$ pour produire à sa sortie un signal A. Les signaux $\overline{A}$ et $\overline{A''}$ sont introduits aux entrées d'une porte ET 47. L'anode de chaque diode $D_{1p}$ (avec p variant de 1 à n) reçoit le signal A, l'anode de chaque diode $D_{2p}$ (avec p variant de 1 à n) reçoit la sortie de la porte ET 47, soit $(\overline{PA_1 + PA_2})$.A, et l'anode de chaque diode $D_{3p}$ (avec p variant de 1 à n) reçoit le signal A" présent en sortie de la porte OU 46. L'indication lumineuse est alors obtenue selon un mode de fonctionnement analogue à celui de la figure 5.

Pour un fonctionnement des diodes en anode commune, les signaux A, A' et $(\overline{PA_1 + PA_2})$.A introduits dans les diodes, cette fois dans leurs cathodes, doivent être bien entendu remplacés par leurs inverses. La porte ET 47 devient par exemple une porte ET inverseuse, et la sortie de l'inverseur $I_{18}$ est reliée à la cathode de la 3ème diode.

La figure 11 illustre les différentes configurations des signaux d'entrée que peut recevoir le détecteur d'accord 30. Comme les récepteurs à modulation de fréquence sont habituellement pourvus d'un discriminateur, le détecteur d'accord 30 reçoit par un circuit 14 le 0 du discriminateur MF. Il reçoit également, dans le cas d'un affichage à trois couleurs, la courbe en S du discriminateur MF, afin de pouvoir produire des signaux tels que $PA_1$ et $PA_2$. En ce qui concerne la modulation d'amplitude, il est également possible de mettre en oeuvre un discriminateur de modulation d'amplitude dont le 0 sera transmis par un circuit 16, et pour une visualisation d'accord à trois couleurs, la courbe en S du discriminateur par un circuit 17. On a représenté également la figure 11 des commutateurs qui permettent de mettre en circuit ou hors circuit alternativement le discriminateur MA et le discriminateur MF par rapport aux entrées du détecteur d'accord 30. Le détecteur d'accord 30 peut également recevoir le champ MF par un circuit 31 et le champ MA par un circuit 32, un commutateur lié au précédent réalisant la commutation. On rappellera que ces indicateurs de champ permettent d'inhiber l'indication d'un accord ou d'un accord approximatif en sortie du détecteur d'accord 30 en présence d'un champ trop faible. Il s'agit donc d'un dispositif généralement utilisé mais qui n'est pas indispensable dans le cadre de l'invention.

D'autre part, on pourra également utiliser dans le cadre de l'invention un circuit de commande d'aiguille lumineuse à éléments discrets, ou bien réaliser une intégration de l'ensemble de l'électronique.

# REVENDICATIONS

1. Récepteur comportant un circuit de réception, un détecteur d'accord (30) associé à un dispositif d'affichage de fréquence qui comporte un circuit de commande d'affichage (20) et un dispositif d'affichage lumineux de fréquence (11), caractérisé en ce que le dispositif d'affichage lumineux (11) consiste en une aiguille lumineuse comprenant une pluralité d'éléments d'affichage ($IL_1$, $IL_2$, ..., $IL_p$, ..., $IL_n$) dont chacun est susceptible de faire apparaître une indication suivant au moins deux couleurs distinctes.

2. Récepteur selon la revendication 1, caractérisé en ce qu'il comporte un circuit (20) de commande d'aiguille lumineuse recevant du circuit de réception (10) du récepteur une tension de commande représentative de la fréquence sur laquelle le récepteur est accordé et produisant en conséquence à une de ses n sorties un signal représentatif de ladite fréquence, le détecteur d'accord (30) recevant dudit circuit de réception (10) un signal représentant le champ reçu et/ou au moins un signal issu d'un discriminateur dudit circuit de réception.

3. Récepteur selon la revendication 1, caractérisé en ce que chaque élément d'affichage est constitué par au moins deux composants électroluminescents ($DR_p$, $DV_p$, $D_{1p}$, $D_{2p}$, $D_{3p}$), en ce qu'il comporte un circuit logique (40) recevant à ses entrées d'une part au moins un signal de sortie du détecteur d'accord et d'autre part les n sorties ($S_1$, $S_2$, ..., $S_p$, ..., $S_n$) du circuit (20) de commande d'aiguille lumineuse et en ce qu'une borne de chaque composant électroluminescent est connectée à une sortie dudit circuit logique (40).

4. Récepteur selon la revendication 3, caractérisé en ce que chaque élément d'affichage est constitué par un premier et un deuxième composant électroluminescents ($DR_p$, $DV_p$), en ce que, dans chaque élément d'affichage ($IL_1$, $IL_2$, ..., $IL_p$, ..., $IL_n$), soit les cathodes, soit les anodes des composants sont réunies ensemble, en ce que le circuit logique (40) comporte soit n groupes de deux portes ET ($PR_p$, $PV_p$, avec p variant de 1 à n) dans le cas où les cathodes des composants sont réunies ensemble, soit n groupes de deux portes ET inverseuses ($P'R_p$, $P'V_p$, avec p variant de 1 à n) dans le cas où les anodes des composants sont réunies ensemble, la sortie de la première ($PR_p$ ou $P'R_p$) et de la deuxième porte ($PV_p$ ou $P'V_p$) de chaque groupe de portes étant reliée à l'électrode libre respectivement du premier ($DR_p$ ou $D'R_p$) et du deuxième ($DV_p$ ou $D'V_p$) composant électroluminescent d'un élément d'affichage correspondant ($IL_p$ ou $I'L_p$), en ce qu'une première entrée de chacune des deux portes ($PR_p$, $PV_p$ ou $P'R_p$, $P'V_p$) d'un groupe reçoit une sortie associée ($S_p$) du circuit (20) de commande d'aiguille lumineuse, avec p variant de 1 à n, en ce que la deuxième entrée de la première porte ($PR_p$ ou $P'R_p$) de chaque groupe reçoit un signal ($\bar{A}$) d'accord exact ou présumé exact du détecteur d'accord (30) selon une logique négative, et en ce que la deuxième entrée de la deuxième porte ($PV_p$ ou $P'V_p$) de chaque groupe reçoit un signal (A) d'accord exact ou présumé exact selon une logique positive.

5. Récepteur selon la revendication 4, caractérisé en ce que le détecteur d'accord (30) reçoit du circuit de réception (10) le signal de zéro et la courbe en S du discriminateur du circuit de réception (10), au moins pour la réception en MF, et produit en sortie également deux signaux ($\overline{PA_1}$ et $\overline{PA_2}$) représentant un accord approximatif, et en ce que le circuit logique (40) comporte un moyen pour introduire à la deuxième entrée de la deuxième porte ($PV_p$ ou $P'V_p$) de chaque groupe un signal $A' = A + PA_1 + PA_2$, $PA_1$ et $PA_2$ représentant un accord approximatif selon une logique positive.

6. Récepteur selon la revendication 5, caractérisé en ce que chaque élément d'affichage ($IL_p$, p variant de 1 à n) est constitué par un premier ($D_{1p}$), un deuxième ($D_{2p}$) et un troisième ($D_{3p}$) composant électroluminescent, en ce que dans chaque élément, soit les anodes, soit les cathodes des composants sont réunies ensemble, en ce que le circuit logique (40) comporte soit n groupes de trois portes ET ($P_{1p}$, $P_{2p}$, $P_{3p}$) dans le cas où les cathodes des composants sont réunies ensemble, soit n groupes de trois portes ET inverseuses dans le cas où les anodes des composants sont réunies ensemble, la sortie des première $(P_{1p})$, deuxième $(P_{2p})$ et troisième $(P_{3p})$ porte de chaque groupe étant reliée à l'électrode libre respectivement du premier $(D_{1p})$, du deuxième $(D_{2p})$ et du troisième $(D_{3p})$ composant électroluminescent d'un élément d'affichage correspondant $(IL_p$, p variant de 1 à n), en ce qu'une première entrée de chacune des trois portes d'un groupe reçoit une sortie associée $(S_p)$ du circuit (20) de commande d'aiguille, selon une logique positive, en ce que la deuxième entrée de la première porte $(P_{1p})$ de chaque groupe reçoit un signal (A) d'accord exact ou présumé exact du détecteur d'accord (30) suivant une logique positive, en ce que le détecteur d'accord (30) reçoit du circuit de récepteur (10) le signal de zéro et la courbe en S du discriminateur du circuit de réception (10), au moins pour la réception en FM, et produit en sortie également deux signaux $(\overline{PA_1}$ et $\overline{PA_2})$ représentant un accord approximatif, en ce que le circuit logique (40) comporte également un moyen pour introduire à la deuxième entrée de la deuxième porte $(P_{2p})$ de chaque groupe un signal logique $(\overline{PA_1} + \overline{PA_2})$ . A, et à la deuxième entrée de la troisième porte $(P_{3p})$ de chaque groupe un signal logique $PA_1 + PA_2$, $PA_1$ et $PA_2$ représentant un accord approximatif selon une logique positive.

7. Récepteur selon la revendication 1, caractérisé en ce que chaque élément d'affichage $(IL_p$, p variant de 1 à n) est constitué d'au moins deux diodes électroluminescentes $(DR_p$, $DV_p)$, en ce que la première électrode de chaque diode électroluminescente reçoit un signal du détecteur d'accord (30), et en ce que dans chaque élément d'affichage $(IL_p)$, les secondes électrodes des diodes électroluminescentes sont reliées entre elles et reçoivent à partir dudit circuit (20) de commande d'aiguille lumineuse un signal correspondant à une logique négative $(\overline{S_p})$ dans un premier cas où lesdites secondes électrodes sont des cathodes, et une logique positive $(S_p)$ dans un second cas où lesdites secondes électrodes sont des anodes.

8. Récepteur selon la revendication 5, caractérisé en ce que chaque élément d'affichage ($IL_p$) est constitué de deux diodes électroluminescentes ($DR_p$, $DV_p$ ou $D'R_p$, $D'V_p$), en ce qu'une première diode ($DR_p$ ou $D'V_p$) de chaque élément d'affichage ($IL_p$) reçoit le signal ($\overline{A}$) d'accord exact ou présumé exact selon une logique négative, et en ce que la deuxième diode ($DV_p$ ou $D'R_p$) de chaque élément d'affichage ($IL_p$) reçoit le signal (A) d'accord exact ou présumé exact inversé par rapport au précédent.

9. Récepteur selon la revendication 8, caractérisé en ce que le détecteur d'accord (30) reçoit du circuit de réception (10) le signal de zéro et la courbe en S du discriminateur du circuit de réception, au moins pour la réception en MF, et produit en sortie également deux signaux ($\overline{PA_1}$ et $\overline{PA_2}$) représentant un accord approximatif, en ce que ladite première diode ($DR_p$) de chaque élément d'affichage ($IL_p$) reçoit le signal d'accord exact ou présumé exact selon une logique négative $\overline{A}$ dans le premier cas et une logique positive A dans le second cas, et en ce qu'il comporte un moyen pour fournir à la seconde diode un signal $A' = PA_1 + A + PA_2$ dans le premier cas et un signal $\overline{A'} = \overline{PA_1 + A + PA_2}$ dans le second cas.

10. Récepteur selon la revendication 7, caractérisé en ce que chaque élément d'affichage ($IL_p$) est constitué d'une première, d'une deuxième et d'une troisième diode électroluminescente ($D_{1p}$, $D_{2p}$, $D_{3p}$), en ce que le détecteur d'accord (30) reçoit du circuit de réception (10) le signal de zéro et la courbe en S du discriminateur du circuit de réception (10), au moins pour la réception en MF, et produit en sortie également deux signaux ($\overline{PA_1}$, $\overline{PA_2}$) représentant un accord approximatif, en ce que la première électrode des premières diodes ($D_{1p}$, p variant de 1 à n) reçoit le signal d'accord exact ou présumé exact selon une logique positive dans le premier cas et une logique négative dans le second cas, en ce qu'il comporte un moyen pour introduire à la première électrode des deuxièmes diodes ($D_{2p}$) un signal logique ($\overline{PA_1} + \overline{PA_2}$). A dans le premier cas et son inverse dans le second, et à la première électrode des troisièmes diodes ($D_{3p}$) un signal logique $PA_1 + PA_2$ dans le premier cas et son inverse dans le cas contraire, $PA_1$ et $PA_2$ représentant un accord approximatif selon une logique positive.

11. Récepteur selon l'une des revendications précédentes, caractérisé en ce que, pour une émission MA, le détecteur d'accord (30) reçoit du circuit de réception (10) le champ MA, et/ou le zéro et la courbe en S d'un discriminateur MA.

12. Récepteur selon l'une des revendications 1 à 4, 7 et 8, caractérisé en ce que, pour une émission MF, le détecteur d'accord (30) reçoit du circuit de réception (10) au moins le zéro du discriminateur.

13. Récepteur selon l'une des revendications précédentes, caractérisé en ce que, pour une émission MF, le détecteur d'accord (30) reçoit le champ MF, de manière à ne pas donner de signal d'accord lorsque le champ est inférieur à une valeur donnée.

0073707

1/5

FIG_1

FIG_2

0073707

FIG_3

FIG_4

FIG_5

# FIG_6

DETECTEUR D'ACCORD — 30

$\bar{A}$   I9   A

DR1  DV1   DRp  DVp

IL1  $S\bar{1}$   $S\bar{2}$   $S\bar{3}$   $S\bar{p}$  ILp   $S\bar{n}$

I11   I12   I13   I10+p   I10+n

20 — S1   S2   S3 ——— Sp ——————— Sn

CIRCUIT DE COMMANDE
D'AIGUILLE LUMINEUSE

# FIG_7

DETECTEUR D'ACCORD — 30

$\bar{A}$   I10   A

D'R1  DV1   D'Rp  D'Vp

IL1   D'R1   D'Vp   ILp

20 — S1   S2   S3 ——— Sp ——————— Sn

CIRCUIT DE COMMANDE
D'AIGUILLE LUMINEUSE

FIG_8

CIRCUIT DE COMMANDE D'AIGUILLE LUMINEUSE

0073707

FIG_9

FIG_10

FIG_11

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| | --- | | H 03 J    1/02 |
| Y | US-A-3 882 399  (O.KARPOWYCZ)<br><br>*Figure  1; colonne 1, ligne 62 - colonne  2,  ligne 13; colonne 2, ligne 35 - colonne 3, ligne 45* | 1-3,7, 11,12 | H 03 J    3/14 |
| | --- | | |
| Y | DE-A-2 741 506  (KORTING RADIOWERKE)<br>*Figures  1,2;  page 2, ligne 7 - page 5, ligne 14* | 1-3,7, 11,12 | |
| | --- | | |
| A | DE-A-2 944 915  (BLAUPUNKT WERKE)<br>*Figure 1; page 3, ligne 6 - page 6, ligne 16* | 1,4,6 | |
| | --- | | |
| A | US-A-4 165 500  (A.MISAWA)<br>*Figure 7 et figure 9; colonne 1, lignes 9-51; colonne 3, ligne 3 - colonne 4, ligne 10* | 11-13 | **DOMAINES TECHNIQUES RECHERCHES (Int. Cl. 3)** |
| | --- | | |
| A | RADIOMENTOR ELECTRONIC, année 44, no. 9, septembre 1978, pages 342-343, Munich (DE);<br>H.FORSTER:   "FM-Radioskala   mit LEDs". | | H 03 J<br>G 01 R |
| | ----- | | |

Le présent rapport de recherche a été établi pour toutes les revendications

| Lieu de la recherche | Date d'achèvement de la recherche | Examinateur |
|---|---|---|
| LA HAYE | 07-12-1982 | DHONDT I.E.E. |